(19) **Europäisches Patentamt**
**European Patent Office**
**Office européen des brevets**

(11) **EP 3 602 230 B1**

(12) **EUROPEAN PATENT SPECIFICATION**

(45) Date of publication and mention of the grant of the patent:
**06.01.2021 Bulletin 2021/01**

(51) Int Cl.:
***G05F 1/56*** *(2006.01)*  ***H03M 1/66*** *(2006.01)*

(21) Application number: **18721141.2**

(22) Date of filing: **02.04.2018**

(86) International application number:
**PCT/IB2018/052257**

(87) International publication number:
**WO 2018/178957 (04.10.2018 Gazette 2018/40)**

(54) **A RECONFIGURABLE VOLTAGE CONTROLLED CURRENT-VOLTAGE SOURCE DEVICE AND DIGITAL-TO-ANALOGUE CONVERTER COMPRISING IT**

REKONFIGURIERBARE SPANNUNGSGESTEUERTE STROMSPANNUNGSQUELLENVORRICHTUNG UND DIGITAL-ANALOG-WANDLER, SIEUMFASSEND

DISPOSITIF DE SOURCE DE COURANT/TENSION COMMANDÉE EN TENSION RECONFIGURABLE ET CONVERTISSEUR NUMÉRIQUE/ANALOGIQUE LE COMPRENANT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **30.03.2017 PT 2017109996**

(43) Date of publication of application:
**05.02.2020 Bulletin 2020/06**

(73) Proprietor: **Instituto Politécnico De Leiria**
**2411-901 Leiria (PT)**

(72) Inventors:
• **GUERREIRO E SILVA, António Egídio**
**3100-320 Pombal (PT)**

• **FERREIRA MIRANDA, Nuno Miguel**
**2410 -338 Leiria (PT)**
• **MOREIRA MENDES, Luís Miguel**
**2415-474 Leiria (PT)**

(74) Representative: **do Nascimento Gomes, Rui**
**J. Pereira da Cruz, S.A.**
**Rua Victor Cordon, 10-A**
**1249-103 Lisboa (PT)**

(56) References cited:
**CN-A- 103 197 224** **JP-A- 2011 135 198**
**US-A1- 2010 283 647**

## Description

### FIELD OF THE INVENTION

The present invention is enclosed in the area of voltage / voltage and voltage / current conversion, in particular with reconfigurable properties, and more specifically applied to digital-to-analogue conversion.

### PRIOR ART

Several types of digital-to-analogue converters (DAC) exist in the art, having in common the fact that such DAC either has a current or voltage output, but not both.

Nevertheless, there are integrated circuits that combine DACs and analogue circuitry providing current and voltage outputs.

In these circuits, the current and voltage outputs are assigned to different pins and use different analogue blocks for each output, thereby increasing complexity, layout area and power consumption.

Moreover, the current output of these DACs is usually unidirectional, which reduces the range of applications where the DAC can be used.

Patent application CN 103 197 224 discloses a multi-channel OLED life testing system based on a Howland current pump, which allows to know how much current flows through the OLED test sample, and thereby allows to know several parameters of each branch of the circuit.

Patent application JP 2011135198 discloses a current/voltage conversion combining output device with a simple configuration.

Patent application US 2010/283647 discloses a multi-mode digital-to-analog converter (DAC) configured to operate in a plurality of modes.

To improve the versatility, flexibility and solve the drawbacks above mentioned, the present invention provides a simple and reliable solution for the reconfiguration of the output, thereby providing an output current or an output voltage in the same output pin, as well as bipolar output voltages and bidirectional currents.

### SUMMARY OF THE INVENTION

It is an object of the present invention to provide a reconfigurable voltage controlled current-voltage source device. This is achieved by the features defined in the attached set of claims.

The reconfigurable current-voltage source device of the present invention thereby provides a bidirectional output, i.e., it has the ability to source or sink a current from a load, such load being connected to the referred single signal output. Therefore, it enables the usage of a single circuitry, providing a single output. The differential amplifier feeds a load connected to the single signal output, thereby having a similar functionality to that of the Howland based circuits or of the voltage controlled voltage source. The secondary amplifiers specifically provide mitigation of the effects of the resistances of the switches on the circuit performance. Furthermore, they work as voltage buffers and improve the isolation between the single output and the two inputs, facilitating the resistance matching between the two feedback paths (positive and negative feedback paths). Furthermore, the operation mode of the reconfigurable voltage controlled current-voltage source is selected by the proper combination of the switches states (unlocked/open or locked/closed). The actual topology allows the hot switching between the two operation modes.

The switches are arranged so that:

- the first switch connects an input of the first secondary amplifier with the output of the differential amplifier,
- the second switch connects an input of the first secondary amplifier with the single signal output,
- the third switch connects an input of the second secondary amplifier with the single signal output, and
- the fourth switch connects an input of the second secondary amplifier with a voltage reference, such voltage reference preferably consisting of the ground.

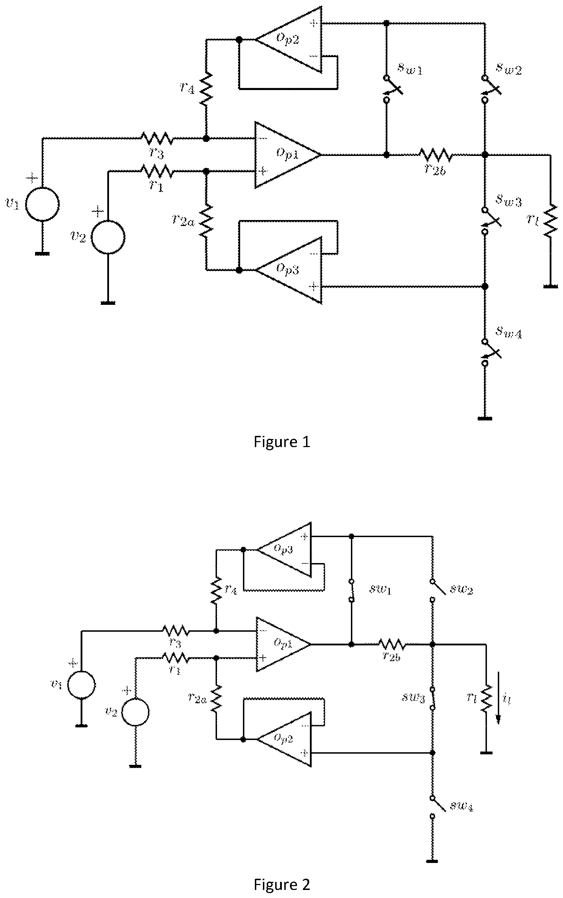

Such configuration is that of Figure 1, the secondary amplifiers being connected in a voltage follower configuration, thereby consisting of an enhanced version of that, more general, above described.

Thus, when working in controlled current source mode, the first switch and the third switch are locked/closed and the second switch and the fourth switch unlocked/open (Figure 2, in such case the secondary amplifiers being connected in a voltage follower configuration).

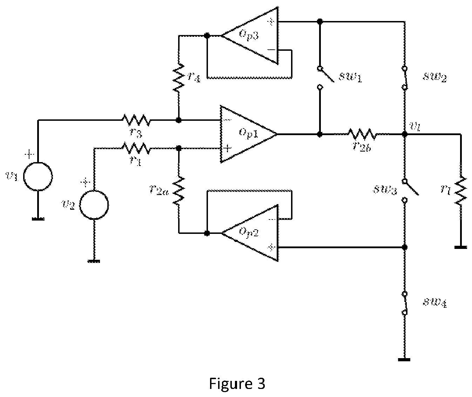

When in controlled voltage source mode the second switch and the fourth switch are locked/closed and the first switch and the third switch are unlocked/open (Figure 3, in such case the secondary amplifiers being connected in a voltage follower configuration).

In the device of the present invention, the secondary amplifiers are connected in a voltage follower configuration, the first secondary amplifier thereby providing a first voltage follower and the second secondary amplifier thereby providing a second voltage follower. Such configuration is presented in Figure 1. For such voltage follower configuration:

- the first switch specifically connects the non-inverting input of the first voltage follower with the output of the differential amplifier,
- the second switch specifically connects the non-inverting input of the first voltage follower with the single signal output,
- the third switch specifically connects the non-inverting input of the second voltage follower with the single signal output, and

- the fourth switch specifically connects the non-inverting input of the second voltage follower with a voltage reference, such voltage reference preferably consisting of the ground.

In an inventive aspect of the circuit of the present invention, the first, second, third and fourth resistors respect the following relation:

$$\frac{r_4}{r_3} = \frac{r_{2a}}{r_1}.$$

Such relation balances the transconductances relative to each of the inputs, providing the best possible performance.

It is also an object of the present invention a reconfigurable digital-to-analogue converter comprising digital-to-analogue conversion circuitry, an output block and a single analogue output, the output block comprising the voltage controlled current-voltage source device according to any of the described configurations and the single output consisting of the single signal output of such device. Such DAC provides output reconfigurable, providing a single output and a single output block/driver, unlike those known in the art. Preferably, it further comprises a control unit, such control unit being configured to control the locking/unlocking of any of the four switches. Such inventive aspect of the DAC of the present invention therefore provides for automatic reconfigurable of the DAC and, accordingly, of the device of the present invention.

It is yet an object of the present invention an apparatus for reconfigurable digital-to-analogue conversion comprising the digital-to-analogue converter according to any of the described configurations and a microcontroller (or microprocessor), such microcontroller being configured to instruct the control unit to control the locking/unlocking of any of the four switches. Such apparatus preferably consists of a building automation equipment, an environment monitoring system, an industry process controller, a field sensor, a medical equipment or a communication electronic system.

## DESCRIPTION OF FIGURES

Figure 1 - representation of an embodiment of the circuit of the present invention. The circuit has two signal inputs $v_1$ and $v_2$, which can be used as a differential input, one single signal output (through the resistance $r_l$) and comprises i) the differential amplifier ($O_{p1}$), ii) the two secondary amplifiers, in such case operational amplifiers each arranged in a voltage follower fashion ($O_{p2}$ and $O_{p3}$), iii) four switches ($S_{w1}$, $S_{w2}$, $S_{w3}$ and $S_{w4}$) and iv) five resistors ($r_1$, $r_{2a}$,

$r_3$, $r_4$, and $r_{2b}$). The load of the circuit is represented in Figure 1 by the load resistor $r_l$. The reconfigurable voltage controlled current-voltage source that is able to operate in two operation modes, one working as controlled current source and the other as a controlled voltage source.

Figure 2 - representation of the circuit of Figure 1 in controlled current source mode, in which the first and third switches $S_{w1}$ and $S_{w3}$ are locked/closed and the second and fourth switches $S_{w2}$ and $S_{w4}$ are unlocked/open. Passage of current $i_l$ on a load $r_l$, representing the single signal output, is shown.

Figure 3 - representation of the circuit of Figure 1 in controlled voltage source mode, in which the first and third switches $S_{w1}$ and $S_{w3}$ are unlocked/open and the second and fourth switches are locked/closed $S_{w2}$ and $S_{w4}$.

## DETAILED DESCRIPTION

The more general and inventive aspects of the device, DAC and apparatus of the present invention are described in the Summary of the invention. Such configurations are detailed below in accordance with other advantageous and/or preferred embodiments of implementation of the present invention.

In several possible embodiments of the device of the present invention, the switches consist of mechanical switches, electrical controlled mechanical switches or solid state (semiconductor) switches. The switches can be developed in any technology that allows the implementation of switches or circuits that have similar function/operation of a switch. To achieve a reconfigurable voltage controlled current-voltage source device with an ideal performance the open resistance of each switch should tend to infinite and the closed resistance of each switch should tend to zero. In practice, the performance rises as the ratio between the open and closed resistances of the switch increases.

In additional possible embodiments of the device of the present invention, the differential amplifier and the secondary amplifiers consist of operational amplifiers or transconductance amplifiers. These amplifiers can be developed/implemented in any technology and take any form and topology.

In an embodiment of the device of the present invention, each of the secondary amplifiers provides a unitary gain.

In a further embodiment of the device of the present invention, the two signal inputs consist of voltage signal inputs and, optionally, are arranged forming a balanced differential input.

Alternatively, the two signal inputs consist of current signal inputs, $r_4 \cong r_{2a}$ and $r_3 = r_1 = 0$, thereby providing an optimal performance with a current signal input.

In yet another embodiment of the device of the present invention, it further comprises a control unit, such unit being configured to control the locking/unlocking of any of the four switches, preferably the control unit being specifically configured to alter the state of the four switches so that the first and third switches have a same state, which is opposite to that of the second and fourth switches, which thereby also have a same state. The device is therefore autonomous as regards its reconfiguration abilities.

In an embodiment of the converter of the present invention comprising a control unit, such control unit is specifically configured to alter the state of the four switches so that the first and third switches have a same state, which is opposite to that of the second and fourth switches, which thereby also have a same state. Preferably, the control unit is specifically configured to:

- lock the first switch and the third switch and unlock the second switch and the fourth switch, thereby configuring the single output as a current output, and
- lock the second switch and the fourth switch and unlock the first switch and the third switch, thereby configuring the single output as a voltage output.

An embodiment of the device of the present invention is subsequently described.

The circuit topology of the present invention is independent of the technology used to develop and implement the reconfigurable voltage controlled current-voltage source device (and all its internal blocks/circuits) and, for that reason, can be implemented with discrete and / or integrated blocks / components available in any technology. The circuit topology, which is based on the enhanced Howland current source and on the voltage differential amplifier, allows the converter to operate as a controlled voltage source or as a controlled current source with a configurable functionality. The developed converter has two inputs, which can be used as differential input, and a bidirectional output, i.e., it has the ability to source or sink a current from the load. All these features provide a distinct versatility when compared to others (some available in the market), due to the many applications that can take advantage using it. For instance, the presented circuit can constitute the microcontrollers DAC output driver. In this application, where the pin count is important, the output type could be chosen or altered by software. In the test and measurement area, the presented circuit can be part of controllable voltage / current sources to characterize the performance of discrete and integrated circuits. Nevertheless, there are many other possibilities that one can figure out.

Figure 1 presents the circuit of the present invention. As can be seen, the circuit has two signal inputs $v_1$ and $v_2$, which can be used as a differential input, one single signal output and comprises i) a differential amplifier ($O_{p1}$), ii) the two secondary amplifiers, in such case operational amplifiers each arranged in a voltage follower fashion ($O_{p2}$ and $O_{p3}$), iii) four switches ($S_{w1}$, $S_{w2}$, $S_{w3}$ and $S_{w4}$) and iv) five resistors ($r_1$, $r_{2a}$, $r_3$, $r_4$, and $r_{2b}$). The load of the circuit is represented in Figure 1 by the load resistor $r_l$. The reconfigurable voltage controlled current-voltage source is able to operate in two operation modes, one working as controlled current source and the other as a controlled voltage source. Besides that, the actual topology allows the hot switching between the two operation modes. The operation mode is selected by the proper combination of the states of the four switches of the circuit represented in Figure 1. When working in current source mode, the first and third switches $S_{w1}$ and $S_{w3}$ are closed and the second and fourth switches $S_{w2}$ and $S_{w4}$ open. On the other hand, when the reconfigurable voltage controlled current-voltage source is operating in voltage source mode, the second and fourth switches $S_{w2}$ and $S_{w4}$ are closed and the first and third switches $S_{w1}$ and $S_{w3}$ are open. All the switches can be implemented using discrete and/or integrated technologies and can be mechanical switches, electrical controlled mechanical switches or solid state (semiconductor) switches or any other form. To achieve a reconfigurable voltage controlled current-voltage source device with an ideal performance the open resistance of each switch should tend to infinite and the closed resistance of each switch should tend to zero. In practice, the performance rises as the ratio between the open and closed resistances of the switch increases.

The circuit has three amplifiers (e.g. OPAMPs): the differential amplifier $O_{p1}$ (herein referred as the main amplifier) and the first $O_{p2}$ and second $O_{p3}$ secondary amplifiers, operational amplifiers arranged in a voltage follower configuration. The amplifiers can be implemented in any available technology, be discrete or integrated and have any topology. The open loop gain, gain-bandwidth product, stability (gain and phase margin), slew-rate, distortion levels (total harmonic / intermodulation distortion), input referred voltage / current noise, input (common and differential) and output impedance, input offset voltage, offset drift, input common-mode voltage range, common-mode rejection ratio, output voltage / current swing and power supply rejection ration of the amplifiers are examples of important parameters that should be considered when implementing a reconfigurable voltage controlled current-voltage source device.

The functionality of the main amplifier, $O_{p1}$, is similar to the one of the enhanced Howland circuit or to the one of the voltage differential amplifier, depending on the selected operation mode. Thus, $O_{p1}$ is of paramount importance to the performance of the circuit of the present invention. It is this amplifier that feeds the load of the reconfigurable voltage controlled current-voltage source. Thus, the current driving characteristics of the reconfigurable voltage controlled current-voltage source device is limited by the main amplifier $O_{p1}$.

The amplifiers $O_{p2}$ and $O_{p3}$, can be connected in any topology as long as the gain of these amplifiers is equal to a predetermined value. In Figure 1, each secondary amplifier is implemented with one OPAMP configured / connected as a voltage follower or voltage buffer. Thus, both feedback amplifiers of the Figure 1 have a unity gain. The $O_{p2}$ and $O_{p3}$ amplifiers are used to improve the isolation between the output and the inputs, to facilitate the resistance matching between the two feedback paths (positive and negative feedback paths) and to mitigate the effects of the resistances of the switches on the circuit performance. Depending on the type of switches used in the reconfigurable voltage controlled current-voltage source, the input impedances of $O_{p2}$ and $O_{p3}$ can have a nefarious impact on the performance of the circuit of the present invention if their input impedance values are lower than a given minimum value.

The circuit of the present invention uses five resistors ($r_1$, $r_{2a}$, $r_3$, $r_4$, and $r_{2b}$). These resistors can be of any type and implemented with any available technology. The resistor characteristics, like its resistance accuracy, resistance frequency dependency (associated with parasitic elements), resistance nonlinearity, resistance temperature coefficient and power rating, are important to the design of the circuit of the present invention since the attainable performance is also dependent on the resistors. The resistors of the circuit of the present invention can take any resistance value. To achieve a reconfigurable controlled current-voltage source device with an ideal performance, the resistors $r_1$, $r_{2a}$, $r_3$ and $r_4$ should verify the following equation

$$\frac{r_4}{r_3} = \frac{r_{2a}}{r_1}.$$

The resistor $r_{2b}$ is also important to the performance of the circuit of the present invention since the circuit transconductance is dependent of $r_{2b}$.

Yet another embodiment of the device of the present invention is subsequently described.

Figure 1 shows the two main operation modes of the circuit of the present invention, one working as current source and the other as voltage source. The operating mode is select by the proper combination of the four switches. When working in current source mode, the switches $S_{w1}$ and $S_{w3}$ are locked and $S_{w2}$ and $S_{w4}$ unlocked, when in voltage source mode the $S_{w2}$ and $S_{w4}$ are locked and $S_{w1}$ and $S_{w3}$ are unlocked. The circuit has three OAMPs and the $O_{p1}$ can be considered as the main OPAM. Its functionality is similar to as in Howland based circuit or as in the voltage to voltage converter, depending of the operation mode is selected. The $O_{p3}$ is used to improve the resistance ratio between the two branches of the circuit (one providing positive feedback and other providing negative feedback), buffering the voltage at the positive branch and consequently isolating the current. The $O_{p2}$ cuts-off the current that flows in the negative branch making possible the merging of the tree circuits.

The two secondary amplifiers $O_{p2}$ and $O_{p3}$ con-

figured as voltage buffers are used to mitigate the parasitic resistances caused by the switches presence in the circuit. This circuit has two OAMPs working exclusively as voltage buffers and one implementing the circuit operation selected by switches and at same time feeding the load.

Another embodiment of the device of the present invention is subsequently described.

As referred, the circuit provides two distinct operation modes. These operation modes are achieved by using the appropriated topology that is achieved by the proper conjugation of four switches.

This circuit has two main functionalities with same output, more, it can perform a warm reconfiguration without a physical change of output or input connectors. Therefore, it can be used in two operation modes:

- Voltage controlled current source;
- Voltage controlled voltage source.

This reconfigurable capacity of the proposed final circuit it is one of its best characteristics and is not present in prior art. Each of the chosen operation mode was based on specific parameters such as linearity, output resistance and the possibility of controlling the output from an input voltage (controlled source) in conjugation with a differential input. The presented proposal circuit gathers these ideal characteristics in order to provide directly the supply to a DUT or to be the output block of a DAC.

In Figure 2 is shown the current mode operation mode and in Figure 3 the voltage source operation mode. For simplicity, the switch control circuit is not shown.

As will be clear to one skilled in the art, the present invention should not be limited to the embodiments described herein, and a number of changes are possible without departing from the scope of the attached claims.

The preferred embodiments shown above are combinable, in the different possible forms, being herein avoided the repetition all such combinations.

## Claims

1. A reconfigurable voltage controlled current-voltage source device comprising two signal inputs ($v_1$, $v_2$), a single signal output, five resistors, a differential amplifier ($O_{p1}$) and two secondary amplifiers ($O_{p2}$, $O_{p3}$), wherein:

    - the five resistors consist of first, second, third, fourth and fifth resistor;
    - the two signal inputs ($v_1$, $v_2$) consist of a first and a second signal input ($v_1$, $v_2$), wherein:

        ◦ the first signal input ($v_1$) is connected to an inverting input of the differential amplifier

($O_{p1}$) through the third resistor $r_3$, and

∘ the second signal input ($v_2$) is connected to a non-inverting input of the differential amplifier ($O_{p1}$) through the first resistor $r_1$;

- the output of the differential amplifier ($O_{p1}$) is connected to the single signal output through the fifth resistor $r_{2b}$;
- the two secondary amplifiers ($O_{p2}$, $O_{p3}$) consist of:

∘ a first secondary amplifier ($O_{p2}$) in which:

■ an output is connected to the inverting input of the differential amplifier ($O_{p1}$) through the fourth resistor $r_4$, and
■ it is part of a negative feedback loop of the differential amplifier ($O_{p1}$);

∘ a second secondary amplifier ($O_{p3}$) in which:

■ an output is connected to the non-inverting input of the differential amplifier ($O_{p1}$) through the second resistor $r_{2a}$, and
■ it is part of a positive feedback loop of the differential amplifier ($O_{p1}$);

wherein the device further comprises four switches ($S_{w1}$, $S_{w2}$, $S_{w3}$, $S_{w4}$), the four switches ($S_{w1}$, $S_{w2}$, $S_{w3}$, $S_{w4}$) being so arranged that:

∘ when a first switch ($S_{w1}$) and a third switch ($S_{w3}$) are locked and a second switch ($S_{w2}$) and a fourth switch ($S_{w4}$) unlocked, the voltage controlled current-voltage source device operates in current source mode, and
∘ when a second switch ($S_{w2}$) and a fourth switch ($S_{w4}$) are locked and a first switch ($S_{w1}$) and a third switch ($S_{w3}$) unlocked, the voltage controlled current-voltage source device operates in voltage source mode,

wherein the secondary amplifiers ($O_{p2}$, $O_{p3}$) are connected in a voltage follower configuration, the first secondary amplifier ($O_{p2}$) thereby providing a first voltage follower and the second secondary amplifier ($O_{p3}$) thereby providing a second voltage follower, and wherein:

- the first switch ($S_{w1}$) connects the non-inverting input of the first voltage follower with the output of the differential amplifier ($O_{p1}$),
- the second switch ($S_{w2}$) connects the non-inverting input of the first voltage follower with the single signal output,
- the third switch ($S_{w3}$) connects the non-inverting input of the second voltage follower with the single signal output, and
- the fourth switch ($S_{w4}$) connects the non-inverting input of the second voltage follower with a voltage reference, such voltage reference consisting of the ground.

2. Device according to the previous claim wherein the first, second, third and fourth resistors respect the following relation:

$$\frac{r_4}{r_3} = \frac{r_{2a}}{r_1},$$

3. Device according to any of the preceding claims wherein each of voltage followers provides a unitary gain.

4. Device according to any of the preceding claims, wherein the switches consist of mechanical switches, electrical controlled mechanical switches or solid state switches.

5. Device according to any of the preceding claims, wherein the differential amplifier ($O_{p1}$) and the secondary amplifiers ($O_{p2}$, $O_{p3}$) consist of operational amplifiers or transconductance amplifiers.

6. Device according to any of the preceding claims wherein the two signal inputs ($v_1$, $v_2$) consist of voltage signal inputs.

7. Device according to the previous claim wherein the voltage signal inputs are arranged forming a balanced differential input.

8. Device according to any of the claims 1-5 the two signal inputs ($v_1$, $v_2$) consist of current signal inputs, in which $r_4 \cong r_{2a}$ and $r_3 = r_1 = 0$.

9. Device according to any of the preceding claims wherein it further comprises a control unit, such unit being configured to control the locking/unlocking of any of the four switches ($S_{w1}$, $S_{w2}$, $S_{w3}$, $S_{w4}$), preferably the control unit being further configured to alter the state of the four switches ($S_{w1}$, $S_{w2}$, $S_{w3}$, $S_{w4}$) so that the first ($S_{w1}$) and third switches ($S_{w3}$) have a same state, which is opposite to that of the second ($S_{w2}$) and fourth switches ($S_{w4}$), which thereby also have a same state.

10. Reconfigurable digital-to-analogue converter comprising digital-to-analogue conversion circuitry, an output block and a single analogue output, the output block comprising the voltage controlled current-voltage source device of any of the claims 1-9 and the single output consisting of the single signal output of such device.

11. Converter according to the previous claim wherein it further comprises a control unit, such control unit being configured to control the locking/unlocking of any of the four switches ($S_{w1}$, $S_{w2}$, $S_{w3}$, $S_{w4}$) wherein, optionally, the control unit is further configured to alter the state of the four switches ($S_{w1}$, $S_{w2}$, $S_{w3}$, $S_{w4}$) so that the first ($S_{w1}$) and third switches ($S_{w3}$) have a same state, which is opposite to that of the second ($S_{w2}$) and fourth switches ($S_{w4}$), which thereby also have a same state.

12. Converter according to the previous claim wherein the control unit is further configured to:

- lock the first switch ($S_{w1}$) and the third switch ($S_{w3}$) and unlock the second switch ($S_{w2}$) and the fourth switch ($S_{w4}$), thereby configuring the single output as a current output, and
- lock the second switch ($S_{w2}$) and the fourth switch ($S_{w4}$) and unlock the first switch ($S_{w1}$) and the third switch ($S_{w3}$), thereby configuring the single output as a voltage output.

13. Apparatus for reconfigurable digital-to-analogue conversion comprising the digital-to-analogue converter of any of the claims 10-12 and a microcontroller, such microcontroller being configured to instruct the control unit to control the locking/unlocking of any of the four switches ($S_{w1}$, $S_{w2}$, $S_{w3}$, $S_{w4}$).

14. Apparatus according to the previous claim, wherein it consists of a building automation equipment, an environment monitoring system, an industry process controller, a field sensor, a medical equipment or a communication electronic system.

**Patentansprüche**

1. Ein rekonfigurierbares spannungsgesteuertes Strom-Spannungs-Quellgerät, welches zwei Signaleingänge ($v_1$, $v_2$), einen einzigen Signalausgang, fünf Widerstände, einen Differenzverstärker ($O_{p1}$) und zwei sekundäre Verstärker ($O_{p2}$, $O_{p3}$) **umfasst,** worin:

- die fünf Widerstände aus erstem, zweitem, drittem, viertem und fünftem Widerstand bestehen;
- die zwei Signaleingänge ($v_1$, $v_2$) aus einem ersten und einem zweiten Signaleingang ($v_1$, $v_2$) bestehen, worin:

◦ der erste Signaleingang ($v_1$) durch den dritten Widerstand $r_3$ zu einem invertierten Eingang des Differenzverstärkers ($O_{p1}$) verbunden ist, und

◦ der zweite Signaleingang ($v_2$) durch den ersten Widerstand $r_1$ zu einem nicht invertierten Eingang des Differenzverstärkers ($O_{p1}$) verbunden ist;

- der Ausgang des Differenzverstärkers ($O_{p1}$) ist zu dem einzigen Signalausgang durch den fünften Widerstand $r_{2b}$ verbunden;
- die zwei sekundären Verstärker ($O_{p2}$, $O_{p3}$) bestehen aus:

◦ einem ersten sekundären Verstärker ($O_{p2}$), in dem:

■ ein Ausgang durch den vierten Widerstand $r_4$ zu dem invertierten Eingang des Differenzverstärkers ($O_{p1}$) verbunden ist, und
■ es Teil einer negativen Rückkopplungsschleife des Differenzverstärkers ($O_{p1}$) ist;

◦ einem zweiten sekundären Verstärker ($O_{p3}$), in dem:

■ ein Ausgang durch den zweiten Widerstand $r_{2a}$ zu dem nicht invertierten Eingang des Differenzverstärkers ($O_{p1}$) verbunden ist, und
■ es Teil einer positiven Rückkopplungsschleife des Differenzverstärkers ($O_{p1}$) ist;

**worin** das Gerät zusätzlich vier Schalter ($S_{w1}$, $S_{w2}$, $S_{w3}$, $S_{w4}$) umfasst, die vier Schalter ($S_{w1}$, $S_{w2}$, $S_{w3}$, $S_{w4}$) sind so angeordnet, dass:

◦ wenn ein erster Schalter ($S_{w1}$) und ein dritter Schalter ($S_{w3}$) gesperrt sind und ein zweiter Schalter ($S_{w2}$) und ein vierter Schalter ($S_{w4}$) entsperrt sind, das spannungsgesteuerte Strom-Spannungs-Quellgerät im Stromquellemodus arbeitet, und
◦ wenn ein zweiter Schalter ($S_{w2}$) und ein vierter Schalter ($S_{w4}$) gesperrt sind und ein erster Schalter ($S_{w1}$) und ein dritter Schalter ($S_{w3}$) entsperrt sind, das spannungsgesteuerte Strom-Spannungs-Quellgerät in Spannungsquellemodus arbeitet,

worin die sekundären Verstärker ($O_{p2}$, $O_{p3}$) in einer Spannungsfolgerkonfiguration verbunden sind, wodurch der erste sekundäre Verstärker ($O_{p2}$) einen ersten Spannungsfolger bereitstellt und der zweite sekundäre Verstärker ($O_{p3}$) einen zweiten Spannungsfolger bereitstellt, und worin:

- der erste Schalter ($S_{w1}$) den nicht invertierten Eingang des ersten Spannungsfolgerss mit dem Ausgang des Differenzverstärkers ($O_{p1}$) verbindet,
- der zweite Schalter ($S_{w2}$) den nicht invertierten Eingang des ersten Spannungsfolgers mit dem einzigen Signalausgang verbindet,
- der dritte Schalter ($S_{w3}$) den nicht invertierten Eingang des zweiten Spannungsfolgers mit dem einzigen Signalausgang verbindet, und
- der vierte Schalter ($S_{w4}$) den nicht invertierten Eingang des zweiten Spannungsfolgers mit einer Spannungsreferenz verbindet, diese Spannungsreferenz besteht aus dem Boden.

2. Gerät nach dem vorherigen Anspruch, worin bei dem ersten, dem zweiten, dem dritten und dem vierten Widerstand folgendes Verhältnis beachtet wird:

$$\frac{r_4}{r_3} = \frac{r_{2a}}{r_1},$$

3. Gerät nach jedem der vorherigen Ansprüche, worin jeder der Spannungsfolger eine einheitliche Verstärkung bereitstellt.

4. Gerät nach jedem der vorherigen Ansprüche, worin die Schalter aus mechanischen Schaltern, elektrisch gesteuerte mechanische Schalter oder Halbleiterschalter bestehen.

5. Gerät nach jedem der vorherigen Ansprüche, worin der Differenzverstärker ($O_{p1}$) und die sekundären Verstärker ($O_{p2}$, $O_{p3}$) aus Operationsverstärkern oder Transkonduktanzverstärkern bestehen.

6. Gerät nach jedem der vorherigen Ansprüche, worin die zwei Signaleingänge ($v_1$, $v_2$) aus Spannungssignaleingänge bestehen.

7. Gerät nach dem vorherigen Anspruch, worin die Spannungssignaleingänge so angeordnet sind, dass sie einen symmetrischen Differentialeingang bilden.

8. Gerät nach jedem der Ansprüche 1-5, die zwei Signaleingänge ($v_1$, $v_2$) bestehen aus Stromsignaleingängen, in denen $r_4 \cong r_{2a}$ und $r_3 = r_1 = 0$.

9. Gerät nach jedem der vorherigen Ansprüche, worin es zusätzlich eine Steuereinheit umfasst, diese Einheit ist konfiguriert um, die Sperrung und die Entsperrung jeder der vier Schalter ($S_{w1}$, $S_{w2}$, $S_{w3}$, $S_{w4}$) zu steuern, vorzugsweise ist die Steuereinheit weiterhin so konfiguriert, dass sie den Zustand der vier Schalter ($S_{w1}$, $S_{w2}$, $S_{w3}$, $S_{w4}$) verändert, sodass der erste ($S_{w1}$) und der dritte Schalter ($S_{w3}$) einen gleichen Zustand haben, der entgegengesetzt zu dem des zweiten ($S_{w2}$) und vierten Schalters ($S_{w4}$) ist, die dabei auch einen gleichen Zustand haben.

10. Rekonfigurierbarer Digital-Analog-Wandler, der einen Digital-Analog-Umwandlungsschaltkreis, einen Ausgangsblock und einen einzigen Analogausgang **umfasst,** der Ausgangsblock umfasst das spannungsgesteuerte Strom-Spannungs-Quellgerät jeder der Ansprüche 1-9 und der einzige Analogausgang besteht aus dem einzigen Signalausgang dieses Gerätes.

11. Wandler nach vorherigem Anspruch, worin er zusätzlich eine Steuereinheit umfasst, diese Steuereinheit ist konfiguriert um, die Sperrung und die Entsperrung jeder der vier Schalter ($S_{w1}$, $S_{w2}$, $S_{w3}$, $S_{w4}$) zu steuern, worin, die Steuereinheit, wahlweise, weiterhin konfiguriert ist, den Zustand der vier Schalter ($S_{w1}$, $S_{w2}$, $S_{w3}$, $S_{w4}$) zu verändern, sodass der erste ($S_{w1}$) und der dritte Schalter ($S_{w3}$) einen gleichen Zustand haben, der entgegengesetzt zu dem des zweiten ($S_{w2}$) und vierten Schalters ($S_{w4}$) ist, die dabei auch einen gleichen Zustand haben.

12. Wandler nach dem vorherigen Anspruch, worin die Steuereinheit zusätzlich konfiguriert ist, um:

- den ersten Schalter ($S_{w1}$) und den dritten Schalter ($S_{w3}$) zu sperren und den zweiten Schalter ($S_{w2}$) und den vierten Schalter ($S_{w4}$) zu entsperren, wobei der einzige Ausgang als ein Stromausgang konfiguriert ist, und
- den zweiten Schalter ($S_{w2}$) und den vierten Schalter ($S_{w4}$) zu sperren und den ersten Schalter ($S_{w1}$) und den dritten Schalter ($S_{w3}$) zu entsperren, wobei der einzige Ausgang als ein Spannungsausgang konfiguriert ist.

13. Apparat für rekonfigurierbare Analog-DigitalWandlung, welcher einen Digital-Analog-Wandler jeder der Ansprüche 10-12 und einen Mikrokontroller **umfasst,** dieser Mikrokontroller ist konfiguriert, um die Steuereinheit zu beauftragen die Sperrung und Entsperrung jeder der vier Schalter ($S_{w1}$, $S_{w2}$, $S_{w3}$, $S_{w4}$) zu kontrollieren.

14. Apparat nach vorherigem Anspruch, worin dieser aus einer Konstruktionsautomatisierungseinrichtung, ein Umweltbeobachtungssystem, einer Industrieprozesssteuerung, ein Feldsensor, eine medizinische Ausrüstung oder ein elektronisches Kommunikationssystem besteht.

### Revendications

1. Un reconfigurable dispositif de source de courant et de tension commandé par la tension, **comprenant** deux entrées de signal (v1, v2), une sortie unique de signal, cinq résistances, un amplificateur différentiel ($O_{p1}$) et deux amplificateurs secondaires ($O_{p2}$, $O_{p3}$), dans lequel:

- les cinq résistances se composent de la première, deuxième, troisième, quatrième et cinquième résistances;
- les deux entrées de signal (v1, v2) se composent de une première et une deuxième entrées de signal (v1, v2), où:

 ◦ la première entrée de signal (v1) est connectée à une entrée inverse de l'amplificateur différentiel ($O_{p1}$) par la troisième résistance $r_3$, et
 ◦ la deuxième entrée de signal (v2) est connectée à une entrée non inverse de l'amplificateur différentiel ($O_{p1}$) par la première résistance $r_1$;

- la sortie de l'amplificateur différentiel ($O_{p1}$) est connecté à la sortie unique de signal par la cinquième résistance $r_{2b}$;
- les deux amplificateurs secondaires ($O_{p2}$, $O_{p3}$) se composent:

 ◦ un premier amplificateur secondaire ($O_{p2}$) dans lequel:

  ■ une sortie est connectée à l'entrée inverse de l'amplificateur différentiel ($O_{p1}$) par la quatrième résistance $r_4$, et
  ■ il fait partie d'une boucle de rétroaction négative de l'amplificateur différentiel ($O_{p1}$) ;

 ◦ un deuxième amplificateur secondaire ($O_{p3}$) dans lequel:

  ■ une sortie est connectée à l'entrée non inverse de l'amplificateur différentiel ($O_{p1}$) par la deuxième résistance $r_{2a}$, et
  ■ il fait partie d'une boucle de rétroaction positive de l'amplificateur différentiel ($O_{p1}$) ;

**dans lequel** le dispositif comprend en outre quatre commutateurs ($S_{w1}$, $S_{w2}$, $S_{w3}$, $S_{w4}$), les quatre commutateurs ($S_{w1}$, $S_{w2}$, $S_{w3}$, $S_{w4}$) étant ainsi arrangés:

 ◦ lorsqu'un premier commutateur ($S_{w1}$) et un troisième commutateur ($S_{w3}$) sont verrouillés et un deuxième commutateur ($S_{w2}$) et un quatrième commutateur ($S_{w4}$) déverrouillés, le dispositif de source de courant et de tension commandé par la tension fonctionne en mode de source de courant, et
 ◦ lorsqu'un deuxième commutateur ($S_{w2}$) et un quatrième commutateur ($S_{w4}$) sont verrouillés et un premier commutateur ($S_{w1}$) et un troisième commutateur ($S_{w3}$) déverrouillés, le dispositif de source de courant et de tension commandé par la tension fonctionne en mode source de tension,

où les amplificateurs secondaires ($O_{p2}$, $O_{p3}$) sont connectés dans une configuration de suiveur de tension, le premier amplificateur secondaire ($O_{p2}$) fournissant ainsi un premier suiveur de tension et le second amplificateur secondaire ($O_{p3}$) fournissant ainsi un deuxième suiveur de tension, et dans lequel:

- le premier commutateur ($S_{w1}$) relie l'entrée non inverse du premier suiveur de tension à la sortie de l'amplificateur différentiel ($O_{p1}$),
- le deuxième commutateur ($S_{w2}$) relie l'entrée non inverse du premier suiveur de tension à la sortie unique de signal,
- le troisième commutateur ($S_{w3}$) relie l'entrée non inverse du second suiveur de tension à la sortie unique de signal, et
- le quatrième commutateur ($S_{w4}$) relie l'entrée non inverse du second suiveur de tension à une référence de tension, cette référence de tension étant constituée par la terre.

2. Dispositif selon la revendication précédente dans lequel les première, deuxième, troisième et quatrième résistances respectent la relation suivante:

$$\frac{r_4}{r_3} = \frac{r_{2a}}{r_1},$$

3. Dispositif selon l'une des revendications précédentes dans lequel chacun des suiveurs de tension fournit un gain unitaire.

4. Dispositif selon l'une des revendications précédentes, dans lequel les commutateurs se composent des commutateurs mécaniques, des commutateurs mécaniques à commande électrique ou des commutateurs à l'état solide.

5. Dispositif selon l'une des revendications précédentes, dans lequel l'amplificateur différentiel ($O_{p1}$) et les amplificateurs secondaires ($O_{p2}$, $O_{p3}$) sont constitués d'amplificateurs opérationnels ou d'amplificateurs de transconductance.

6. Dispositif selon l'une des revendications précédentes, dans lequel les deux entrées de signal (v1, v2) sont constituées d'entrées de signal de tension.

**7.** Dispositif selon la revendication précédente, dans lequel les entrées de signaux de tension sont disposées en formant une entrée différentielle équilibrée.

**8.** Dispositif selon l'une des revendications 1 à 5, où les deux entrées de signal (v1, v2) sont constituées d'entrées de signal de courant, dans lequel $r_4 \cong r_{2a}$ et $r_3 = r_1 = 0$.

**9.** Dispositif selon l'une des revendications précédentes, dans lequel il comprend en outre une unité de commande, cette unité étant configurée pour commander le verrouillage/déverrouillage de l'un quelconque des quatre commutateurs ($S_{w1}$, $S_{w2}$, $S_{w3}$, $S_{w4}$), de préférence l'unité de commande étant en outre configurée pour modifier l'état des quatre commutateurs ($S_{w1}$, $S_{w2}$, $S_{w3}$, $S_{w4}$), afin que le premier ($S_{w1}$) et le troisième commutateurs ($S_{w3}$) ont un même état, qui est opposé à celui de le deuxième ($S_{w2}$) et le quatrième commutateurs ($S_{w4}$), qui ont donc également un même état.

**10.** Convertisseur numérique/analogique reconfigurable **comprenant** circuiterie de conversion numérique/analogique, un bloc de sortie et une sortie analogique unique, le bloc de sortie comprenant le dispositif de source de courant et de tension commandé par la tension de l'une des revendications 1 à 9, et la sortie unique consistant en la sortie unique de signal de ce dispositif.

**11.** Convertisseur selon la revendication précédente, dans lequel il comprend en outre une unité de commande, cette unité de commande étant configurée pour commander le verrouillage/déverrouillage de l'un quelconque des quatre commutateurs ($S_{w1}$, $S_{w2}$, $S_{w3}$, $S_{w4}$), dans lequel, en option, l'unité de commande est en outre configurée pour modifier l'état des quatre commutateurs ($S_{w1}$, $S_{w2}$, $S_{w3}$, $S_{w4}$), afin que le premier ($S_{w1}$) et le troisième commutateurs ($S_{w3}$) ont un même état, qui est opposé à celui de le deuxième ($S_{w2}$) et le quatrième commutateurs ($S_{w4}$), qui ont donc également un même état.

**12.** Convertisseur selon la revendication précédente, dans lequel l'unité de commande est en outre configurée pour:

- verrouiller le premier commutateur ($S_{w1}$) et le troisième commutateur ($S_{w3}$) et déverrouiller le deuxième commutateur ($S_{w2}$) et le quatrième commutateur ($S_{w4}$), configurant ainsi la sortie unique comme une sortie de courant, et
- verrouiller le deuxième commutateur ($S_{w2}$) et le quatrième commutateur ($S_{w4}$) et déverrouiller le premier commutateur ($S_{w1}$) et le troisième commutateur ($S_{w3}$), configurant ainsi la sortie unique comme une sortie en tension.

**13.** Appareil de conversion numérique/analogique reconfigurable **comprenant** le convertisseur numérique/analogique de l'une quelconque des revendications 10 à 12 et un microcontrôleur, ce microcontrôleur étant configuré pour ordonner à l'unité de commande de commander le verrouillage/déverrouillage de l'un quelconque des quatre commutateurs ($S_{w1}$, $S_{w2}$, $S_{w3}$, $S_{w4}$).

**14.** Appareil selon la revendication précédente, dans lequel il consiste en un équipement d'automatisation de bâtiment, un système de surveillance de l'environnement, un contrôleur de processus industriel, un capteur de terrain, un équipement médical ou un système électronique de communication.

Figure 1

Figure 2

Figure 3

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 103197224
- JP 2011135198 B
- US 2010283647 A